# EUROPEAN PATENT APPLICATION

(11) **EP 4 385 943 A1**
(43) Date of publication of application: **19.06.2024**
(21) Application number: 22213103.9
(22) Date of filing: 13.12.2022
(51) Int. Cl.: B81B 3/00

(54) **STOPPER BUMP ON ROTOR**

(71) Applicant: Murata Manufacturing Co., Ltd., Nagaokakyo-shi, Kyoto 617-8555 (JP)
(72) Inventor: LIUKKU, Matti, 00400 Helsinki (FI); LEHTINEN, Pekka, 01760 Vantaa (FI)
(74) Representative: Boco IP Oy Ab

(57) **Abstract**

A microelectromechanical element comprising a motion-limiting structure which is configured to prevent a main rotor body from coming into direct physical contact with a stator across a vertical rotor-stator gap. The motion-limiting structure comprises a first stopper bump which is a protrusion on the stator which extends toward the rotor. The motion-limiting structure also comprises a second stopper bump, and the second stopper bump is a protrusion on the rotor which extends from the main rotor body toward the stator.

## Description

### FIELD OF THE DISCLOSURE

The disclosure relates to microelectromechanical (MEMS) elements, and more particularly to MEMS elements where a mobile rotor moves close to a fixed stator. The present disclosure further concerns motion limiters which prevent direct contact between the main rotor body and the stator.

### BACKGROUND OF THE DISCLOSURE

Microelectromechanical (MEMS) devices such as accelerometers and gyroscopes often comprise a mass element which is suspended from fixed anchors with a flexible suspension structure which allows the mass element to move in relation to adjacent fixed structures. This mobile mass element may be called a rotor and a fixed device part which is adjacent to the rotor may be called a stator. Such fixed parts may include walls which form an enclosure around the mobile parts of the MEMS device. The movement of the rotor may be measured for example with capacitive measurements where the rotor itself is used as one electrode and a counter-electrode is placed on an adjacent stator.

Direct physical contact between the rotor and the stator is usually not desirable because it may disturb the operation of the device. The rotor and its suspension structure can be dimensioned so that direct contact does not occur in regular operation, but exceptional external shocks may still displace the rotor so much that it comes into direct contact with the stator, causing structural damage, electrical short-circuits or other faults.

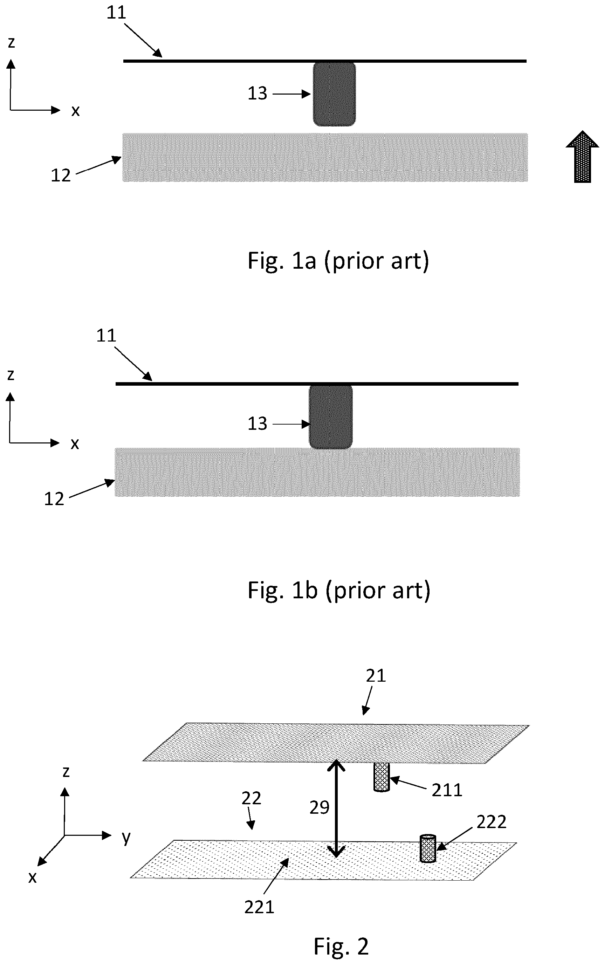

Motion limiters can be implemented in MEMS devices to reduce shock damage. It is known from the prior art (figures 1a and 1b) that a motion limiter may comprise a bump 13 which is attached to the stator 11 and extends from the stator toward the rotor 12. The bump will then be the first part which comes into contact with the rotor in the event of an external shock which moves the rotor 12 in the z-direction. The bump 13 prevents direct contact between the other parts of the rotor 12 and the stator. However, a general challenge with motion bumps is that the impact between the rotor 12 and the bump 13 can be so hard that it releases debris from the rotor. This debris can disturb device operation. Softer impacts can be achieved by utilizing multiple bumps.

### BRIEF DESCRIPTION OF THE DISCLOSURE

An object of the present disclosure is to provide a motion limiter for limiting out-of-plane movement and a method for manufacturing such a motion limiter.

The object of the disclosure is achieved by an arrangement and a method which are characterized by what is stated in the independent claims. The preferred embodiments of the disclosure are disclosed in the dependent claims.

The disclosure is based on the idea of having one stopper bump extend from the stator toward the rotor, while the other one extends from the rotor toward the stator. This arrangement allows a variety of out-of-plane motion limiters to be constructed.

### BRIEF DESCRIPTION OF THE DRAWINGS

In the following the disclosure will be described in greater detail by means of preferred embodiments with reference to the accompanying drawings, in which
Figures 1a - 1b illustrate a motion limiter known from the prior art.
Figure 2 illustrates a microelectromechanical element with a motion limiter.
Figure 3a illustrates a rotor which undergoes rotational motion.
Figure 3b illustrated a rotor which undergoes linear motion.
Figures 4a - 4c illustrate a rotor with an impact absorber.
Figures 5a - 5d illustrate rotors with two surface regions which have different z-coordinates.

### DETAILED DESCRIPTION OF THE DISCLOSURE

This disclosure describes a microelectromechanical element comprising a mobile rotor in a device layer. The device layer defines an xy-plane and a z-direction which is perpendicular to the xy-plane. The mobile rotor comprises a main rotor body. The microelectromechanical element also comprises a fixed stator which is adjacent to the mobile rotor and separated from the mobile rotor in the z-direction by a rotor-stator gap.

The microelectromechanical element also comprises a motion-limiting structure which is configured to prevent the main rotor body from coming into direct physical contact with the stator across the rotor-stator gap. The motion-limiting structure comprises a first stopper bump. The first stopper bump is a protrusion on the stator which extends toward the rotor. The motion limiting structure also comprises a second stopper bump. The second stopper bump is a protrusion on the rotor which extends from the main rotor body toward the stator.

A stator which is adjacent to the rotor in a MEMS device may be any part of the device layer which (unlike the rotor) remains fixed to a given position with respect to surrounding fixed structures regardless of the movement experienced by the device. The stator may be used as a fixed reference point in a measurement which tracks the movement of the rotor, for example in a capacitive measurement arrangement where a set of electrodes is prepared on the stator and a set of counter-electrodes is prepared on the rotor. A piezoelectric measurement arrangement may alternatively be prepared on a flexible suspender which extends from the stator to the rotor. However, the fixed stator discussed in this disclosure does not have to be a structure which is used for measuring the movement of the rotor. The device may contain multiple stator structures which can be used for different purposes.

The mobile rotor is a part which can move a single body in relation to surrounding fixed structures. The rotor may for example be formed in the device layer by etching. A suspension structure comprising flexible springs may be formed between the rotor and the fixed parts of the device layer by etching the device layer. The suspension structure may be significantly more flexible for some kinds of movement than other kinds of movement. The geometry and location of the springs will for example determine whether an external force in the z-direction will set the rotor in rotational motion or translational motion out of the device plane.

The device layer defines a device plane, which is illustrated as the xy-plane in this disclosure. The device plane may for example be defined by a wafer or a layer deposited on a surface, wherein the rotor has been manufactured in said wafer or layer. The rotor may be made of silicon.

The device plane may also be referred to as the horizontal plane. A direction which is perpendicular to the device plane is in this disclosure illustrated with a z-axis, and it may be called the vertical direction or the out-of-plane direction. The words "horizontal" and "vertical" refer in this disclosure only to a plane and to a direction which is perpendicular to that plane. They do not imply anything about how the device should be oriented with respect to the earth's gravitational field when the device is manufactured or used. The same also applies to related terms such as "above" and "below", "high" and "low", "up" and "down".

In some technical applications, the rotor may be designed to undergo linear out-of-plane motion where the entire rotor moves out of the device plane. In other applications, the rotor may be designed to undergo rotational out-of-plane motion where it rotates about an axis which lies in the device plane. These design options will also influence how the rotor moves under the influence of an external shock in the z-direction. This disclosure presents motion limiters intended for limiting linear and rotational out-of-plane motion, or any other kind of out-of-plane motion.

The motion-limiting structure comprises a first stopper bump and a second stopper bump, and it is configured to prevent the rotor from coming into direct physical contact with the stator. The first and second stopper bumps are protrusions on the stator and the rotor, respectively. The first stopper bump may be formed from a layer of silicon dioxide which is deposited on the stator and then patterned. The second stopper bump may be formed by patterning the rotor itself, or it may be formed by a depositing a layer on the rotor and patterning this layer. Other options are also possible.

The rotor has a main rotor body, and the purpose of the motion-limiting structure is to prevent this main rotor body from coming into direct physical contact with the stator. In the event of a strong external shock, the contact will instead occur between the first stopper bump and the main rotor body and/or between the second stopper bump and the stator. The places where these two impacts occur can be selected through suitable placement and dimensioning of the first and second stopper bumps. This placement and dimensioning can be selected in a way which minimizes the risk of structural damage.

The microelectromechanical element may be an accelerometer or a gyroscope. The device part which is the mobile rotor may in some applications be called a mass element, a proof mass or a Coriolis mass. The rotor is in its rest position when no transducing force or external force acts upon it. The rotor may be moved away from its rest position, and for example driven into oscillating movement, by a force transducer built into the MEMS element. The rotor may also be moved away from its rest position by external forces which act on the MEMS element. A shock is an external force which exceeds the force magnitude that the microelectromechanical element was designed to withstand in normal operation.

Figure 2 illustrates schematically a microelectromechanical element which comprises a mobile rotor 22 and a fixed stator 21. The rotor comprises a main rotor body 221. The element also comprises a fixed stator 21. The rotor and stator are separated by a rotor-stator gap. The purpose of the motion limiter described in this disclosure is to prevent direct contact between the main rotor body 221 and the stator 21 across the rotor-stator gap 29.

The motion limiter comprises a first stopper bump 211. This first stopper bump 211 can for example be formed by depositing an insulating layer on the stator 21 and then patterning the layer. The material of the first stopper bump may for example be silicon dioxide, but many materials can be used.

The rotor comprises a second stopper bump 222, which forms a part of the motion limiter. This stopper bump protrudes from the main rotor body 221 towards the stator 21. The second stopper bump 222 therefore moves with the rotor and it will only come into contact with the stator if the movement of the rotor toward the stator exceeds a predetermined threshold. The second stopper bump may be formed into rotor by etching the rotor. The rotor may be made of silicon, and the protrusion which forms the second stopper bump may then also be made of silicon. Alternatively, an insulating layer can be deposited and patterned on the surface of the rotor to form the protrusion.

Although this disclosure will primarily discuss microelectromechanical elements which comprise one first stopper bump and one or two second stopper bumps, the number first stopper bumps and the number of second stopper bumps can be freely selected. The optimal number will depend on many factors, including the size and geometry of the rotor and its suspension and the kind of impact which is desired at each bump.

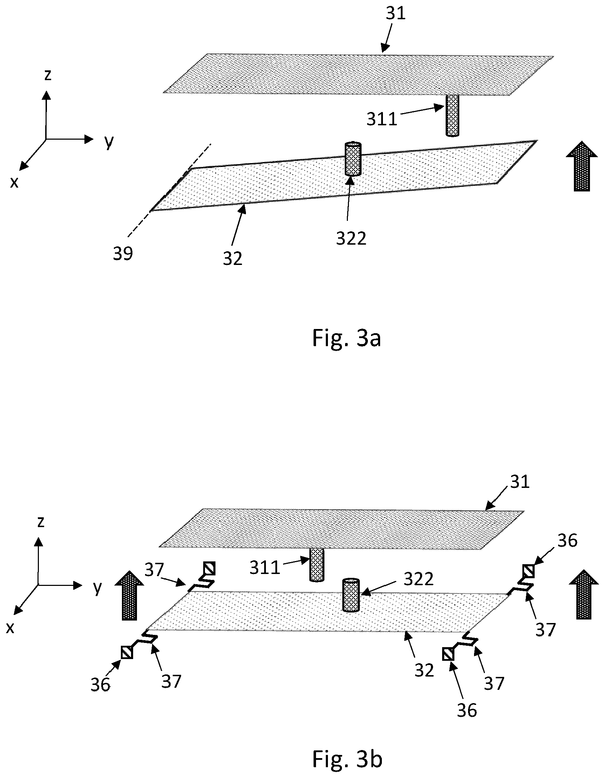

The first and second stopper bumps may be dimensioned and placed so that, when the rotor moves toward the stator in the z-direction and crosses a first displacement threshold, the first stopper bump comes into contact with the rotor but the second stopper bump does not make contact with the stator, and when the rotor continues to move toward the stator in the z-direction and crosses a second displacement threshold, the second stopper bump comes into contact with the stator but the main rotor body does not make contact with the stator. One way to achieve this is to make the first stopper bump longer in the z-direction than the second stopper bump, as figure 3a illustrates. In other words, in any embodiment of this disclosure the first and second stopper bumps may be dimensioned so that the length of the first stopper bump in the z-direction is greater than the length of the second stopper bump in the z-direction. Other arrangements for achieving first contact at the first stopper bump are also possible. If the rotor undergoes rotational motion toward the stator, the first and second stopper bumps could have equal lengths, but the first stopper bump may lie further from the rotation axis than the second stopper bump.

The first and second stopper bumps may be dimensioned and placed so that, when the rotor moves toward the stator in the z-direction and crosses a first displacement threshold, the second stopper bump comes into contact with the stator but the first stopper bump does not make contact with the stator, and when the rotor continues to move toward the stator in the z-direction and crosses a second displacement threshold, the first stopper bump comes into contact with the rotor but the main rotor body does not make contact with the stator. One way to achieve this is to make the second stopper bump longer in the z-direction than the first stopper bump. Other arrangements are also possible for achieving this end.

The expression "when the rotor continues to move toward the stator" means here "in the event that the rotor continues to move toward the stator". If the external shock which moves the rotor past the first displacement threshold (and activates the first stage of the motion-limiting mechanism) is mild, then the first stage may stop the rotor before the second displacement threshold is crossed, and the second stage will not be activated. But in the case of a stronger shock the rotor may keep moving toward the stator even after the first stage was activated, and the movement may continue to the second displacement threshold. These are the events where the second stage of the motion limiter will be activated.

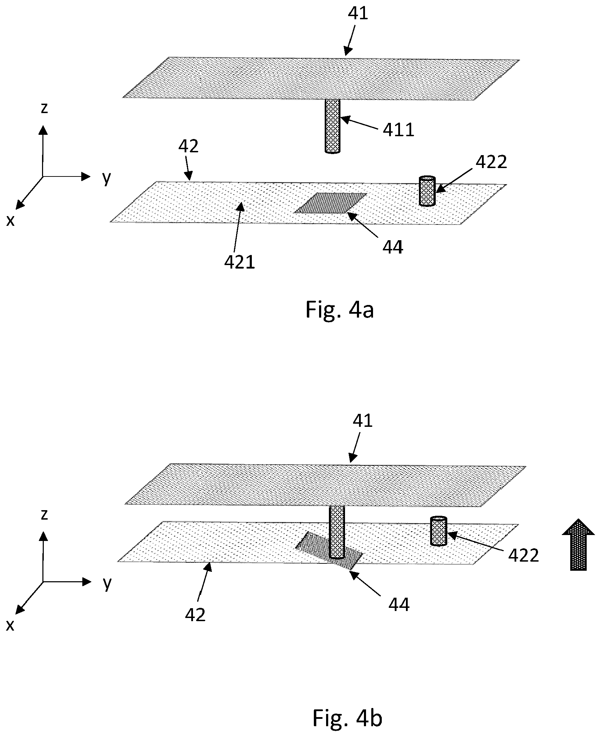

In any embodiment presented in this disclosure, the first and second stopper bumps may be positioned and dimensioned so that the upward momentum of the rotor will continue to carry the main body of the rotor toward the stator even after one of the stopper bumps (for example the first) has made first contact (with the rotor). This movement may involve twisting or bending of the main rotor body. The suspension structure may also allow some tilting in the main rotor body after this first impact. The upward movement of the main rotor body may also continue because the first impact was softened by an impact absorber, as described in more detail below with reference to figure 4a. The twisting, bending or tilting of the rotor may bring the next stopper bump (for example the second) into contact (with the stator) before the movement of the main rotor body stops completely, and before the main rotor body makes physical contact with the stator. In any of these cases, the motion-limiting structure can be called a multi-stage motion limiter.

In any embodiment presented in this disclosure, the first and second stopper bumps may be rigid or substantially rigid, so that they do not flex in the vertical z-direction when they come into contact with the opposing part.

The optimal distances, dimensions and positions of the first and second stopper bumps will depend on the dimensions and structural properties of the rotor, and on the design of the flexible suspension structure of the rotor which determines the movement of the rotor.

The movement of the rotor in the z-direction toward the stator may for example be rotational movement about a rotation axis which lies in the xy-plane. This is illustrated in figure 3a, where reference numbers 31 , 32, 311 and 322 correspond to reference numbers 21, 22, 211 and 222, respectively, in figure 2. The rotor 32 is suspended from a fixed structure with a suspension arrangement (not illustrated) which allows the rotor to undergo rotational motion about the rotation axis 39.

Alternatively, the movement of the rotor in the z-direction toward the stator may be linear translational movement in the z-direction. This is illustrated in figure 3b, where the rotor 32 is suspended from anchor points 36 with a suspension arrangement 37 which is flexible in the z-direction and thereby allows linear movement in this direction.

Regardless of whether the movement of the rotor is rotational or translational, the rotor may comprise an impact absorber. The impact absorber may be attached to the main rotor body with an attachment structure which allows the impact absorber to tilt with respect to the main rotor body. The first stopper bump may be aligned with the impact absorber in the z-direction so that it makes contact with the impact absorber when the rotor crosses the first displacement threshold. In other words, the first stopper bump may be arranged above the impact absorber.

Figure 4a illustrates a microelectromechanical element where reference numbers 41, 42, 411, 421 and 422 correspond to reference numbers 21, 22, 211, 221 and 222, respectively, in figure 2a. The rotor 42 also comprises an impact absorber 44. The impact absorber 44 is attached to the main rotor body 421 with an attachment structure (not illustrated) which allows the impact absorber to tilt upon when the first stopper bump 411 makes contact with it, as figure 4b illustrates. The first impact is thereby softened by the impact absorber. The impact absorber 44 allows the first stopper bump 411 to decrease the upward momentum of the rotor 42 without causing a hard impact on the surface of the rotor 42.

Figure 4b illustrates linear translation of the rotor 42 toward the stator 41, but an impact absorber can also be utilized when the rotor moves in rotational out-of-plane movement toward the stator.

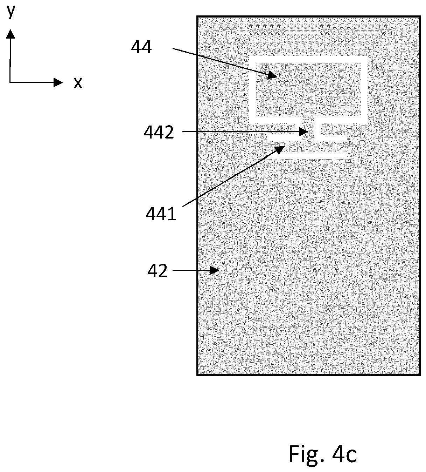

Figure 4c illustrates a possible attachment structure for the impact absorber. The attachment structure may comprise a torsionally flexible first beam 441 which determined the tilting axis of the impact absorber. One or more second beams 442 may extend from the first beam 441 to the impact absorber in the direction is which perpendicular to the first beam. An impact absorber can be implemented in any embodiment presented in this disclosure, and it can be constructed on the main rotor body so that it is aligned with the first stopper bump in the z-direction. A separate impact absorber can be constructed for each first stopper bump if multiple first stopper bumps are used.

In many applications where the rotor undergoes rotational out-of-plane movement toward the stator, the movement of the rotor can be measured with electrodes placed on both sides of the rotation axis. If the rotor is made of a semiconducting material, such as silicon, the rotor itself may be used as one measurement electrode, and counter-electrodes may be arranged for example on the stator. A separate measurement can be performed with each counter-electrode.

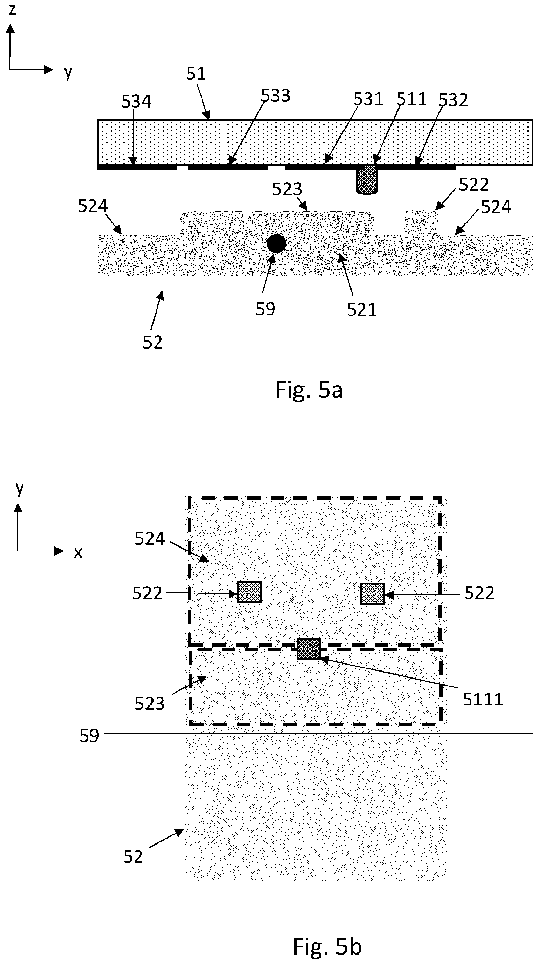

Figure 5a illustrates a microelectromechanical element where reference numbers 51, 511, 52, 522 and 59 correspond to reference numbers 31, 311, 32, 322 and 39, respectively, in figure 3a. Reference number 521 indicates the main rotor body. The element comprises four counter-electrodes 531 - 534 on the surface of the stator 51 which faces the rotor 52. First counter-electrode 531 lies close (in the y-direction) to the rotation axis 59 on a first side (right side in figure 5a) of the rotation axis 59. Second counter-electrode 532 lies further away from the rotation axis 59 on the first side of the rotation axis 59. Third counter-electrode 533 lies close to the rotation axis 59 on a second side (left side in figure 5a) of the rotation axis 59. Fourth counter-electrode 534 lies further away from the rotation axis 59 on the second side of the rotation axis 59.

If the top surface of the rotor is flat, the gap between the rotor surface and the counter-electrode changes significantly faster further away from the rotation axis than close to the rotation axis as the rotor rotates out of the xy-plane. The relationship between the amplitude of the rotational displacement and the amplitude of the measurement signal can then be quite nonlinear.

It can be advantageous to shape the rotor, for example by etching, so that its top surface comprises two different levels in the z-direction. This option is illustrated in figure 5a. The rotor comprises a first surface region 523 and a second surface region 524 which face the stator. The first surface region 523 lies closer to the rotation axis 59 than the second surface region 524. The rotor surface is closer to the stator surface in the first region 523 than in the second surface region 524, so that the z-coordinate of the rotor surface is greater in the first surface region 523 than in the second surface region 524. The second stopper bump 522 lies in the second surface region 524.

The z-coordinate of the top of the second stopper bump 522 may be equal to the z-coordinate of the rotor surface in the first surface region 523, as figure 5a illustrates. This can be achieved by performing an etching process where the top surface of the rotor is recessed throughout the second surface region 524, except for the areas where one or more second stopper bumps will be located. The method for manufacturing the rotor illustrated in figure 5a may comprise performing a local-oxidation-of-silicon (LOCOS) process on the regions of the device layer which will form the second surface region. A second stopper bump 522 formed in a LOCOS process may have a slightly rounded shape without sharp edges, as figure 5a illustrates. This can reduce the risk of damage when this stopper bump comes into contact with the stator. Two consecutive LOCOS processes may alternatively be performed. This allows the z-coordinate of the first surface region 523 to be different (greater or smaller) than the z-coordinate of the top of the second stopper bump 522.

Figure 5b illustrates how the first and second stopper bumps 511 and 522 and the first and second surface regions 523 and 524 may be arranged in the xy-plane. Only the parts of the first and second surface regions which lie on the upper side of the rotation axis 59 in figure 5b have been marked in figure 5b, since that side of the axis is where the stopper bumps are located. In any embodiment presented in this disclosure, stopper bumps could alternatively be arranged on both sides of the rotation axis 59.

The first and second surface regions 523 - 524 are illustrated with dashed lines in figure 5b. The first surface region 523 may be aligned in the z-direction with the counter-electrode 531 and the second surface region 524 may be aligned in the z-direction with the counter-electrode 532, as figure 5a illustrates. In other words, the counter-electrodes may be arranged above the first and second surface regions, respectively. Two second stopper bumps 522 are illustrated within the second surface region 524. The projection 5111 of the first stopper bump 511 onto the surface of the rotor is also illustrated.

As figure 5b illustrates, the projection 5111 of the first stopper bump 511 onto the rotor 52 may for example lie in the middle of the rotor in the x-direction, which is the direction parallel to the rotation axis 59. Alternatively, the first stopper bump could lie on either side of the middle. More than one first stopper bumps may also be used. The microelectromechanical element may for example comprise one first stopper bump aligned with one side (left in figure 5b) of the rotor and another first stopper bump aligned with the opposite side (right) of the rotor.

The first stopper bump 511 partly overlaps with the first (531) and second (532) counter-electrodes in the yz-cross-section of the stator 51 in figure 5a. However, the first and second counter-electrodes may in practice be arranged around the first stopper bump in the xy-plane, so that no counter-electrode is present where the first stopper bump is located. Similarly, an opening can be made in the second counter-electrode 532 to ensure that the second stopper bump 522 comes into contact with an insulating part of the stator 51. Direct contact between the second stopper bump 522 and the second-counter-electrode 532 could short-circuit the measurement. However, events where this contact occurs are expected to be rare, and a short-circuiting impact may for this reason be acceptable. The second counter-electrode 532 would in this case not need to be pattern at all.

The first stopper bump may be at least partly aligned with the first surface region in the z-direction. In other words, the first stopper bump may be arranged above the first surface region. Figure 5b illustrates a device where the projection 5111 of the first stopper bump on the main rotor body lies is aligned with the interface between the first surface region 523 and the second surface region 524. Alternatively, the projection of the first stopper bump could lie entirely within the first surface region 523.

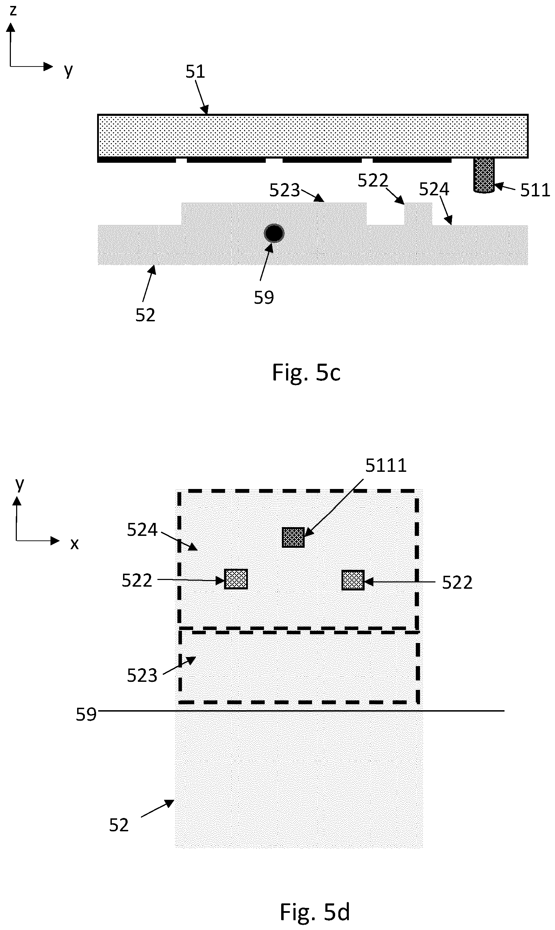

The first stopper bump may be aligned with the second surface region in the z-direction. The first stopper bump is in this case arranged above the second surface region. This option is illustrated in figure 5d, where the second stopper bumps 522 are also in the second surface region 524.

In general, in any embodiment of this disclosure, the first and second stopper bumps may be placed so that each first stopper bump lies further away from the rotation axis than each second stopper bump, as figure 5b illustrates. Alternatively, the first and second stopper bumps may be placed so that each second stopper bump lies further away from the rotation axis than each first stopper bump, as figures 5c and 5d illustrate.

It would also be possible to place the second stopper bump in the first surface region (this option has not been illustrated). The top surface of the rotor will then have to be recessed to multiple levels, so that the first and second surface regions and the top of the second stopper bump are all on different vertical levels. As mentioned earlier two consecutive LOCOS processes may be performed to achieve this objective.

## Claims

1. A microelectromechanical element comprising:
- a mobile rotor in a device layer, wherein the device layer defines an xy-plane and a z-direction which is perpendicular to the xy-plane, and the rotor comprises a main rotor body,
- a fixed stator which is adjacent to the mobile rotor and separated from the rotor in the z-direction by a rotor-stator gap,
a motion-limiting structure which is configured to prevent the main rotor body from coming into direct physical contact with the stator across the rotor-stator gap, wherein the motion-limiting structure comprises a first stopper bump, and the first stopper bump is a protrusion on the stator which extends toward the rotor
**characterized in that** the motion-limiting structure also comprises a second stopper bump, and the second stopper bump is a protrusion on the rotor which extends from the main rotor body toward the stator.

2. A microelectromechanical element according to claim 1, wherein the first and second stopper bumps are dimensioned and placed so that, when the rotor moves toward the stator in the z-direction and crosses a first displacement threshold, the first stopper bump comes into contact with the rotor but the second stopper bump does not make contact with the stator, and when the rotor continues to move toward the stator in the z-direction and crosses a second displacement threshold, the second stopper bump comes into contact with the stator but the main rotor body does not make contact with the stator.

3. A microelectromechanical element according to claim 2, wherein the rotor comprises an impact absorber which is attached to the main rotor body with an attachment structure which allows the impact absorber to tilt with respect to the main rotor body, and the first stopper bump is aligned with the impact absorber in the z-direction so that it makes contact with the impact absorber when the rotor crosses the first displacement threshold.

4. A microelectromechanical element according to claim 1, wherein the first and second stopper bumps are dimensioned and placed so that, when the rotor moves toward the stator in the z-direction and crosses a first displacement threshold, the second stopper bump comes into contact with the stator but the first stopper bump does not make contact with the stator, and when the rotor continues to move toward the stator in the z-direction and crosses a second displacement threshold, the first stopper bump comes into contact with the rotor but the main rotor body does not make contact with the stator.

5. A microelectromechanical element according to any preceding claim, wherein the movement of the rotor in the z-direction toward the stator is rotational movement about a rotation axis which lies in the xy-plane.

6. A microelectromechanical element according to claim 5, wherein the rotor comprises a first surface region and a second surface region which face the stator, and the first surface region lies closer to the rotation axis than the second surface region, and the rotor surface is closer to the stator surface in the first region than in the second surface region, so that the z-coordinate of the rotor surface is greater in the first surface region than in the second surface region, wherein the second stopper bump lies in the second surface region.

7. A microelectromechanical element according to claim 6, wherein the first stopper bump is arranged above the first surface region.

8. A microelectromechanical element according to claim 6, wherein the first stopper bump is arranged above the second surface region.

9. A microelectromechanical element according to claim 8, wherein the first and second stopper bumps are placed so that the first stopper bump lies further away from the rotation axis than the second stopper bump.

10. A microelectromechanical element according to claim 8, wherein the first and second stopper bumps are placed so that the second stopper bump lies further away from the rotation axis than the first stopper bump.
